(19) Europäisches Patentamt
European Patent Office
Office européen des brevets

(11) **EP 3 152 584 B1**

(12) **EUROPEAN PATENT SPECIFICATION**

(45) Date of publication and mention
of the grant of the patent:
**18.12.2024 Bulletin 2024/51**

(21) Application number: **15803553.5**

(22) Date of filing: **03.06.2015**

(51) International Patent Classification (IPC):
**G01R 31/36** (2020.01)   **H01M 10/48** (2006.01)
**G08C 17/02** (2006.01)   **G01S 19/14** (2010.01)
**H04Q 9/00** (2006.01)   **H01M 10/42** (2006.01)
**H01M 10/34** (2006.01)   **G01R 31/371** (2019.01)
**G01R 31/392** (2019.01)

(52) Cooperative Patent Classification (CPC):
**H01M 10/48; G01R 31/371; G01R 31/392;**
**H01M 10/425; H04Q 9/00;** G01S 19/14;
H01M 10/345; H01M 10/486; H01M 2010/4278;
H01M 2220/20; H04Q 2209/40; H04Q 2209/43;
H04Q 2209/823; Y02E 60/10

(86) International application number:
**PCT/FI2015/050384**

(87) International publication number:
**WO 2015/185802 (10.12.2015 Gazette 2015/49)**

(54) **ACCUMULATOR STATE INDICATOR**

AKKUMULATORSTATUSANZEIGE

INDICATEUR D'ÉTAT D'ACCUMULATEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.06.2014 FI 20145523**

(43) Date of publication of application:
**12.04.2017 Bulletin 2017/15**

(73) Proprietor: **CarDoc Oy
90440 Kempele (FI)**

(72) Inventor: **JUVANI, Tapio
90440 Kempele (FI)**

(74) Representative: **Berggren Oy**
**P.O. Box 16**
**Eteläinen Rautatiekatu 10A**
**00101 Helsinki (FI)**

(56) References cited:
**WO-A1-2012/162450    WO-A2-02/09254**
**JP-B2- 3 007 952    JP-B2- 3 364 049**
**US-A1- 2005 001 627    US-A1- 2011 029 157**
**US-A1- 2013 166 233    US-A1- 2014 129 163**
**US-A1- 2014 129 163    US-B1- 6 411 908**
**US-B1- 6 727 708    US-B1- 7 024 321**

**Description**

The present invention relates to predicting the remaining service life of an accumulator.

Background of the invention

Different kinds of accumulators or batteries are needed in many types of machines and devices as a power source in situations, in which supply current is not available or accessible. Especially because of this, accumulators and batteries are used in various mobile devices. Accumulators or batteries are also typically used as reserve power sources. In addition to different machines and vehicles, an accumulator or battery is thus a very widely spread mass product also in industrial equipment and many types of manually controlled consumer devices, for example, in mobile phones or remote controls. For example in combustion engine vehicles an accumulator is use to supply electric current, among others, for the starting of motors and numerous other internal functions of vehicles, such as power source for headlights. The role and performance of an accumulator or battery is thus an important issue and in several applications absolutely critical for the operation of the device.

The basic principle for the operation of an accumulator is an electric couple, i.e. two electrodes and a liquid electrolyte connecting these. The accumulation of electric energy to the accumulator and the use of the accumulator as source for electric current are based on changes between electric energy and chemical energy in the interfaces of electrodes and electrolyte. In accumulators electrodes can be made of metal or metal alloy, lead being one example of a much used electrode material. Electrolyte is also spoken of as accumulator acid, and one typically used electrolyte is sulphuric acid.

There are many types of functional technologies for accumulators, the most typical accumulator options being lead acid batteries, NiCd i.e. nickel-cadmium accumulators, nickel-metal hybrid accumulators and Li-ion i.e. lithium ion accumulators. Many of these substances used in the manufacture of accumulators, such as lead and cadmium, are harmful for the environment. Thus, after the end of its service life, an accumulator is considered hazardous waste from the point of view of nature, which has to be disposed of in an appropriate manner or recycled at the final stage of its service life. Accumulators or batteries must thus not be placed among normal household waste, but own collection bins for example for batteries are available in waste collection points.

$PbO_2$ plate frames (lead oxide) function as the positive electrode for the accumulator in lead accumulators and, in this case, Pb plates work as the negative electrode. The electrolyte can be $H_2SO_4$ (sulphuric acid), which has in practice been diluted with water. Upon discharge of the accumulator, electrode materials i.e. lead oxide and lead both start reacting with sulphuric acid so that lead(II) sulphate ($PbSO_4$) is formed onto the surface of the electrodes. When the accumulator is charged, lead sulphate again transforms back to lead or lead oxide and sulphuric acid. The more the accumulator has discharged, the more lead sulphate has formed onto the surface of the accumulator plates. It is typical for a fully discharged lead accumulator that the electrodes are covered by lead sulphate, and the concentration of the accumulator acid has also diluted close to pure water.

Because an accumulator is hazardous waste, there rises the need to take care of that accumulators removed from use (for example in the form of abandoned cars) do not remain in nature to burden the environment. A problem is thus to in some way observe or keep count of accumulators, which are no longer in working order and which should be reclaimed. Examples of such accumulators are accumulators of abandoned old cars, which may be found in many kinds of places, from backyards to sides of streets and dumps.

On the other hand, it is for in the interest of, for example, a vehicle user to see to that the accumulator is operational also in sub-zero temperatures. In cold conditions it has to be noted that the accumulator does not charge at all as well when it is cold as when it is, for example, in the temperature range of +10 ... +30 degrees. Likewise, the accumulator suffers if it has discharged too empty, i.e. when in case of a lead battery its charge level has sunk below 75%, so much lead sulphate is created that it starts to accumulate into the accumulator cells, and in the long run this considerably shortens the service life of the accumulator. In the economic sense it is preferable that the accumulator is operational as long as possible and that, for example, it would not have to be replaced to a new one excessively often. Thus there are pronounced needs and beneficial factors, and also factors of environmental protection for the monitoring of the performance of the accumulator and, on the other hand, for the prediction of the performance.

In a known technique there have been used separate accumulator testing devices, so called accumulator testers. An accumulator tester provided with versatile functionalities is described in the specification US 8,198,900. The principle of accumulator testers is to connect the tester to the poles of the accumulator, the resistances of the testers then functioning as the load for the accumulator. A disadvantage of accumulator testers is that they are typically used by service and accumulator shops, and that the measurement only tells the situation at the moment of measuring. For example, it may be that the car has just been started and the drive to the service shop is short so that the accumulator has only had a short time to charge. In this case an incorrect diagnosis is easily obtained of the state of the accumulator. In reality the situation under winter conditions can also be that the temperature of the accumulator can be low so that the accumulator can discharge fast, because a cold accumulator does not accept charging current in the same way as, for example, an accumulator in a temperature of +25 degrees. Thus a more realistic indicator of the accumulator state would be a measurement, which would be carried out to an accumulator in room temperature.

A problem with the state of the art is that accumulators are much replaced to new ones in vain, because incorrect diagnoses have been made of the state of the accumulator. In addition, especially vehicle accumulators in the logistics field have been replaced only just in case i.e. to make sure that the vehicle does not die down even in hard frost after the accumulator has been changed. It is also a problem that not all factors and parameters affecting the accumulator have been measured exhaustively, and because of this the measurements of the accumulator state have not given sufficiently authentic results. Also the assessment of the life cycle of accumulators has been very difficult due to inadequate measuring results.

## Summary of the invention

The present invention is set out in the appended set of claims.

## Short description of the drawings

Figure 1a shows a monitoring arrangement of the accumulator, i.e. the measuring circuit with antenna connected to it and the principles for the recording of data and disclosing of user information,

Figure 1b shows a simplified monitoring arrangement of the accumulator, in which the measuring unit of the accumulator transmits the monitoring data directly to the terminal equipment of the interested party,

Figure 2 illustrates a monitoring arrangement of the accumulator, in which sensors, a positioning module and transmitter for the positioning signal are attached to the accumulator as a separate unit and coupled to the measurement circuit,

Figure 3 is a flowchart of the elements used in the process for predicting the service life of the accumulator, and of the initial data, calculation algorithms and other tools used in it,

Figure 4a shows a practical embodiment for observing a dead accumulator at the gate of a dump,

Figure 4b depicts a situation, in which a dead accumulator transmitting a positioning signal can be traced using a manual positioning rake,

Figure 5 illustrates a situation, in which a GPS signal obtained from satellites is used for the positioning so that the necessary GPS receiver is connected to the accumulator, and the data is further transmitted to the terminal device by making use of the telecommunications network, and

Figure 6 illustrates a situation for transmitting the positioning signal to a computer or smart phone of the user or authority by using the telecommunications network.

## Detailed description of the invention

It is an object of the present invention to predict the service life of the accumulator on the basis of conditions and/or measurements, when also the prevailing service life of the accumulator is known.

An embodiment of the invention comprises all kinds of accumulators and batteries functioning as electric power source, irrespective of their application of use, device, location or capacity. Different kinds of vehicles are mentioned in several points in later application examples, but these are only exemplary alternatives; the remaining service life prediction method of the invention is suitable for use in connection with all accumulators and batteries. There may be one or several batteries under examination, because in a typical application a desired number of batteries functioning as power source can be connected in series or in parallel.

In all the following parts of the description, there is description of performance measurements or performance monitoring of an accumulator; these sections are helping with the understanding of the present invention, but they are not specifically part of the present invention. However, the prediction of service life of an accumulator, with all its aspects, are part of the present invention. It is noted that many earlier obtained measurement results are applied in the steps according to the present invention.

It is essential in the measurement of the performance of an accumulator during its life cycle and in the prediction of service life that it must be possible to measure from the accumulator many different functional variables and parameters, which reflect the accumulator's internal operational state, and also from the environment in which the accumulator is located. An important factor in the observation is the quality of measurements so that possible disturbing factors would have as small an impact on the measuring results as possible or that, in any case, it would be possible to identify the existing disturbing factors and eliminate them from the measuring results as well as possible. It is also important to get the measured data into useful use taking the user into consideration, i.e. record and/or transmit the measurement data to a suitable data storage or tool, from which, for example, the car's holder can easily get hold of the data, when needed.

At least one sensor or other necessary indicator is needed for the measurements. In addition, a control unit or other respective unit or device controlling the operation of sensors and measurement data is needed, to which the functional intelligence of a life cycle gauge can be placed. The control unit can be executed in the physical proximity of the accumulator itself as a combination of the controller and necessary electric components, for example, in the form of a circuit board, but also remote control over the network is possible. The apparatus needs signal transmission and reception equipment for telecommunications.

The performance i.e. capacity of the accumulator is determined, among others, based on the state of electrodes and the strength of the accumulator acid solution. In addition, the temperature of the operating environment of the accumulator and thus the temperature of the accumulator itself has a strong impact on how well the accumulator charges and discharges. This is emphasized, for example, in the accumulators of vehicles used in cold winter conditions, in which case the capacity of the accumulator is considerably reduced, compared to summer conditions. More generally speaking, also prevailing humidity, exposure to vibration, discharge and charge cycles, depth of discharge, charging voltage, way of charging (fast or slow), and type and age of the accumulator have an impact on the accumulator's state and life cycle. These things also affect the accumulator's capacity and receptivity of current at a certain moment.

A separate measuring unit has been attached to the accumulator, or a measuring unit has been installed as part of the finished accumulator already during the manufacturing process, the measuring unit being capable to measure several variables form the accumulator and its physical proximity. The measuring unit can also be called a monitoring unit. The measuring unit has preferably been executed onto a circuit board, which has the necessary sensors, components and memory module(s). A controller or other control component can be included in the components, which manages the measurements in the monitoring unit itself. In addition, the circuit board is provided with necessary couplings and connectors for making possible the data transmission to and from the circuit board. Data transmission has been made possible wirelessly by connecting a radio transmitter - receiver unit with antenna to the measuring unit. The antenna is placed so that the travel of the signal is disturbed as little as possible. In one embodiment it is also possible to use an antenna of a car radio located on the roof of the car.

The measuring unit can be integrated as a fixed part of the accumulator already in its manufacturing phase. This means that the measuring unit could not later be detached from the accumulator without breaking the accumulator. In this example the measuring unit has been placed, for example, inside the accumulator's sealing compound either partly or entirely.

In the measuring unit the current feed required by the measuring unit comes directly from the accumulator as long as the accumulator is operational (this limit can be determined as desired; for example, when the voltage of a lead accumulator is over 12.0 V so that the charge level of the accumulator is still over 40% of the charge of a full accumulator). When the accumulator is no longer operational, a separate reserve power source (or battery) is changed as the current feed source of the measuring unit, which is located in connection with or separately from the measuring unit.

Thus the reserve power source starts to feed power to the measuring unit only when the accumulator itself is no longer able to provide the power. In one option the reserve power source in question can be charged from the accumulator as long as the accumulator is operational.

Information on the termination of the accumulator's operational state or life cycle is obtained by measuring the voltage of the accumulator. If the value of the voltage falls below a certain threshold value and the voltage stays below the threshold value at least for a certain set time, it can be concluded that the accumulator is no longer operational.

One or several sensors can be connected to the measuring unit for measuring the desired physical or chemical or electro-magnetic parameter relating to the accumulator or environment. Other things to be measured can be the temperature of the environment, temperature of the accumulator, output voltage and/or current supplied by the accumulator, capacity of the accumulator, specific weight of the electrolyte (water solution of sulphuric acid), electro-magnetic field strength, absolute number or number per time unit of charge and discharge cycles.

In addition, the measuring unit can be connected with a timer, clock or other element keeping track of time or apparatus for monitoring the passing of time and, when needed, for providing a time stamp for each measuring result obtained. When desired, the measuring unit can also be provided with a sensor(s), with which it is possible to measure for example the air pressure or humidity content of the environment.

If necessary, data on the accumulator's make, model and/or type can be included in the data assembled by the measuring unit or data to be recorded in the measuring unit. When desired, the year of manufacture, serial number and/or other identifier identifying the accumulator can be included in the data.

The apparatus contains a positioning unit for the accumulator. The positioning unit can be a separate module or it can be integrated with the measuring unit. If the positioning function has been integrated with the measuring unit, the circuit board components needed in them can be placed onto the same circuit board. Also the software required by the functions can be embedded into one program, in which the functions relating both to the measuring and positioning are run together. The positioning function can be executed with the GPS technology (Global Positioning System).

The measuring unit performs the measurement of parameters on the basis of data obtained from the sensors. When the controller of the measuring unit concludes on the basis of the parameters that the accumulator is not alive and will not return to be operational, the measuring unit activates the positioning unit. The positioning unit starts then or after a defined delay to transmit a positioning signal or other respective signal, which is detectable separately with a suitable receiver (fixed or mobile), and which expresses a non-operational accumulator. One option is to combine the prediction data of service life obtained from the server with the measuring data. If the predicted service life is very short or if a measured parameter is on a critical operational area, the controller makes the positioning unit to transmit the positioning signal.

At least one acceleration sensor can be included in the measuring unit or accumulator or, for example, attached to the outer surface of the accumulator for observing for example, the vibration experienced by the accumulator or more generally, for example, if the vehicle and through that the accumulator attached to the structure of the vehicle is moving or still. Also more serious changes in speed experienced by the car, such as collisions or crashes, can be discovered with the acceleration sensor.

The acceleration sensor or some other sensor (possibly combined with necessary calculation) can be used for identifying the position of the accumulator in relation to ground, if needed. After all it can be thought that an entirely or partially upright accumulator is an indicator of that the accumulator is not attached to the car in a normal manner or, for example, being stored in the garage, but it has landed among household trash or other waste. Such a scenario is possible if, for example, a new or otherwise usable accumulator gets mixed up in a change situation so that a healthy accumulator ends up in trash by accident. The position of the accumulator landed in the trash changes, when household waste is dumped from the refuse container to a garbage truck, from the garbage truck for example to the dump, and for example when emptying large refuse sacks. In this case the positioning unit can be set to transmit the positioning signal, when the position of the accumulator (longitudinal horizontal axis) is detected to deviate from the horizontal plane, for example, by 30 degrees. The value for the angle can naturally be adjusted to a desired one. One option is to set the threshold value to 90 degrees so that the positioning signal activates as the accumulator is on any side or completely upside down.

Another situation, in which the position of the accumulator deviating from the normal position tells about something deviant is, for example, the car suffering a crash, in which the accumulator may move away from its place and the position of the accumulator changes at least a bit. Of course the accumulator may then even disintegrate, but sudden big acceleration occurring in at least smaller crashes and possibly combined with the deviation of the accumulator from the normal can be detected by one or several acceleration sensors. This information on the exceptional deceleration (or acceleration) experienced by the accumulator and observed by the acceleration sensor can be transmitted for example to an authority, such as the emergency service and thus to the emergency personnel, a party in charge of the renting of the car, personnel in charge of vehicles in the logistics field, or service centre managed by the car manufacturer or dealer. Concerning the last example, information on a crash experienced by the car is automatically transmitted to the service centre, and help will arrive at the place without a separate emergency call. By means of the positioning module or GPS application, also exact positioning of the vehicle involved in the crash can be connected to the emergency data. Concerning the accumulator itself, data can also be transmitted to the parties interested in the state and condition of the accumulator, such as environmental authorities and companies engaged in the "after-treatment" of accumulators. After-treatment refers here to the collection and recycling of accumulators at the end of their service life and, if needed, replacing the accumulators with a new replacement accumulator.

The movement, position and vibration data provided by the acceleration sensor can be used so that an accumulator completely still for a long time can be seen from the measurement data. If the still-time of the accumulator is very long and, taking into consideration for example vehicles deliberately in storage over the winter, it can be concluded that at least the accumulator has not been in use or being charged, and the vehicle may have been withdrawn from use entirely. The positioning signal can then be triggered. This application object can be thought to be applied to all accumulators and batteries, which in a normal situation of use are located in a mobile apparatus or machine (so that the accumulator or battery itself is moving).

One essential application, to which the measuring equipment gives an opportunity, is the estimation of the remaining service life of the accumulator and the announcing of this, for example, to the holder of the vehicle using a suitable manner of communication. Estimating the service life is based on the capacity and age of the accumulator, time of the measuring moment, conditions experienced by the accumulator and their variations, and also on the specific weight of the accumulator acid and the amount of lead sulphate. The voltage of lead accumulators provides valuable information for the estimation of the remaining service life. In one embodiment information on the estimated remaining service life of the accumulator is supplied from the server to the mobile phone of the vehicle's user by a command given by the software. With such a notice the car's user can be deftly reached, and the communication does not even require the physical presence of the user by the vehicle itself.

There is a functionality wherein the measuring unit connected to the accumulator activates the transmission of the measured data, positioning signal, alarm, notification, or some other message upon the fulfilment of certain conditions. Such a condition is that the accumulator has been completely empty for a certain predetermined period of time. In another possibility, the condition is the accumulator (and thus the vehicle) staying constantly still for a sufficiently long time so that it can be concluded that the vehicle is fully out of use. In this situation the data on the location, moving and/or position of the accumulator provided by the positioning unit and/or acceleration sensor(s) is used.

The above mentioned positioning signal or respective information can be received by means of a separate receiver. An option is to place the receiver or receivers for example at the dump gate. When an abandoned or exhausted accumulator enters the gate of the dump, let's say among the waste in a garbage truck, the receiver at the gate detects the signal transmitted by the accumulator. Thus the hazardous waste about to arrive at the dump can be detected right at the beginning before the waste becomes mixed with the waste on the dump. On the other hand, the transmitted signal can be selected to be so strong that the accumulator transmitting the signal can be detected already from the distance of a few metres. Thus the accumulator could be detected also from a longer distance and for example from among the waste already on the dump by examining from farther away, such as from the routes, gate or service building at the dump.

On the other hand the positioning can be executed so that as the apparatus is transmitting the positioning signal in question, it can be measured by a separate receiver, with which the incoming direction and strength (amplitude) of the positioning signal can be detected. When the receiver is moved on the area to be examined or around it to different places, an estimate is obtained of the area, in which the accumulator transmitting the positioning signal may be located. If needed, when repeating the measurement in several different places, for example, in the area of the dump, quite an exact estimate is obtained for the estimated location of the accumulator, and after this the search is easier to perform within a more restricted area.

The measured data can be transmitted via radio to a separate server, to which data on all accumulators provided with a measuring unit can be transmitted and recorded for further use and analysis. Data can also be transmitted from the server. When a set of measurement data and type information on different accumulators have been obtained to the server, data mining can be applied to the data set. As an example, measurement data can be analysed so that a data set formed of the temperature variations experienced by the accumulator, accumulator voltage and specific weight of the accumulator acid (sulphuric acid concentration) is created with a framing of accumulators of a certain model and make. An estimate can be generated of the data set as to which service life the accumulator model in question will reach for example in Finnish weather conditions. The mode of use of the accumulator can be included in the estimate as a further parameter, or for example the average or median of the range of uses can be selected as default. When the estimated service life has been calculated on the server and the prevailing service life of the measured accumulator is known, an estimate of the remaining service life is directly obtained, provided that the mode of use of the accumulator will not essentially change from the previous one. This information can be transmitted to the mobile phone of the vehicle's user, for example, in message format (SMS) or by e-mail.

One option is to enter temperature predictions as initial data for the analysis. By combining the previous temperature conditions experienced by the accumulator with the temperature predictions of the near future, an estimate of the performance of the accumulator for the near future can be improved. Especially the seasonal variations can be taken into account in this connection.

On the server level, data provided by the measuring unit can be linked with information previously collected on other accumulators of the accumulator type in question. When the typical behaviour of a certain accumulator type in different weather conditions and the estimated average service life in weather conditions of the place of location of the accumulator are known, valuable further information is obtained for the accumulator to be measured in any phase of its life cycle.

So-called accelerated life test method is used for testing electric components in the present invention. This method has been discussed in Ilpo Jokela's thesis "Accelerated Life Testing", Lahti University of Applied Sciences, 2006. Two different types of acceleration methods are presented relating to the life testing; acceleration of use level and overstressed acceleration. In the latter case more stress is applied to the apparatus so that the normal operating conditions met by the apparatus are exceeded and the failure data thus obtained are set to correspond to the normal operating conditions. In practice, stress factors can comprise e.g. high or low temperature, increased humidity, voltage, pressure and/or vibration, which stimulate the mechanisms for error generation. When speaking of failure frequency a so-called bathtub curve is presented, in which the failure degree or failure frequency increases as a result of the components wearing out on a visible aging period.

The specification presents the so-called Arrhenius calculation model or equation, which can be applied to the life cycle measurement of the invention. In the reliability analysis of electronics the Arrhenius equation determines the rate of occurrence of failures or failure rate depending on the component's temperature (increase in temperature). In this case, the equation is in the form:

$$A_f = e^{\left[\left(\frac{E_a}{k}\right)\left(\frac{1}{T_u} - \frac{1}{T_t}\right)\right]} \quad , \tag{1}$$

in which $A_f$ is the acceleration coefficient, $E_a$ the activation energy, k the Boltzmann constant, $T_u$ the temperature in Kelvin, and Tt the testing temperature in Kelvin.

Activation energy is energy, which is needed for a molecule's participation in a chemical reaction. Thus it measures the impact of temperature i.e. consequence in a reaction. In many practical examples the activation energy is approximately 1.0 eV (Jokela, attachment 4).

A higher temperature causes an increase in the chemical reaction rate. A rule of thumb is that as the apparatus is in a temperature which is 10 degrees higher than normal for a certain time, the situation from the point of view of the device's service life is the same as if the device were in the normal temperature for a double time calculated from the above-mentioned time.

Generally speaking, in addition to the location temperature of the accumulator, also the time the accumulator spends in each temperature, has an impact on the service life of the accumulator. The higher the temperature in relation to +25 degrees, which is considered the optimal temperature, and the longer time the accumulator has to be in the higher temperature, the shorter the service life of the accumulator will be. For example, the service life of a NiMH i.e. nickel-metal hybrid accumulator is reduced by 60% of the normal, if it is constantly exposed to a temperature of 45°C. Further, with all accumulators the self-discharge rate outside the use doubles with each temperature rise of 10°C. The impact of temperature is relatively big, and even small rises in temperature affect the speed of chemical reactions (desired and non-desired) of the accumulator and through that to the reduction in the service life of the accumulator.

Taking time into consideration, the accumulator "wears out" still in a different way relating to whether the accumulator is in use or, for example, unused in a storage. Aging related to time is connected to the English concept "cycle fade", the concept calendar fade" relating to the aging of the accumulator irrespective of use.

The second available calculation model is the so-called Eyring model, which is able to take into consideration also some other type of stress factor in addition to the temperature. In the use of Eyring it has to be taken into account that the impacts of changes in temperature can depend on the extent of other stress factors. The Eyring model for temperature and one other type of stress factor can be written in the form:

$$T_{50} = \left[A T^\alpha e^{\frac{\Delta H}{kT}}\right]\left[e^{\left(B + \frac{C}{T}\right)s}\right] \tag{2}$$

in which S is the function of voltage, current or some other stress factor, and the parameters $\alpha$, $\Delta H$, B and C are acceleration coefficients between the combinations of stress factors.

If it is desired to include humidity in the examination in addition to temperature, an equation presented by H. Livingston is used to calculate the acceleration coefficient ("Guidelines Using Plastic Encapsulated Microcircuits and Semiconductors in Military, Aerospace and Other Rugged Applications", 2000):

$$A_f = \left(\frac{RH_t}{RH_u}\right)^3 e^{\left[\frac{E_a}{k}\left(\frac{1}{T_u} - \frac{1}{T_t}\right)\right]} \quad , \tag{3}$$

in which $RH_u$ is the relative humidity of the use environment and RHt is the relative humidity of the testing environment. Other parameters are as above in connection with the Arrhenius equation.

The so-called Peck calculation model can be used for the separation of the impacts of temperature and humidity and the analysis for calculating the total acceleration coefficient. Here the total acceleration coefficient can be calculated from the form:

$$A_f = e^{\left[\frac{E_a}{k}\left(\frac{1}{T_u} - \frac{1}{T_t}\right)\frac{RHO}{RH}n\right]} \quad , \tag{4}$$

in which $T_u$ and RHO are reference values for temperature and humidity.

The depth of discharge, which is an inverted variable in relation to the charge state, also has an impact on the service life of the accumulator. The smaller the depth of discharge i.e. the bigger the charge state, the longer the service life of the accumulator. The length of the service life grows exponentially as the depth of discharge decreases.

When the accumulator is used, i.e. charged and discharged on a continuous basis, the service life of the accumulator depends typically on the depth and frequency of discharge, charging voltage and ambient temperature.

In lithium accumulators an essential factor relating to the service life is the extent of charging voltage. If the optimum charging voltage is 4.2V, the capacity of the accumulator behaves according to a linearly decreasing function in relation to the service life of the accumulator. If a slightly higher value is set as the charging voltage of the accumulator, such as 4.25V, the achievable capacity after approximately 300 charging times starts to decrease considerably more steeply than during the previous charging times. If the charging voltage is set to 4.35V, the maximum capacity falls below the respective capacity of the optimum charging capacity already after approximately 100 charges, and after this the achievable capacity decreases steeply. Because the interval of the values for the above-mentioned charging voltages is absolutely small, special attention must be paid to that the charging voltage is set as close to the optimal value for the charging voltage of each accumulator type as possible.

One way to define life cycles and their distributions for accumulators is to use the Weibull model, which makes possible the simultaneous examination of several different error modes. In this model the appearance moments of failure can be estimated according to the following equation:

$$F(t) = 1 - e^{-\left(\frac{t}{\alpha}\right)^{\beta}},$$

$$(5)$$

in which F(t) is the cumulative % share of failure after time t, $\alpha$ is the typical service life of components (also scale factor), and $\beta$ is the shape parameter, which describes the distribution of failure. There are also more complicated versions of the Weibull model, which take into account e.g. the location factor, indicating the time delay, after which the effect of failures becomes apparent. All failures are not necessarily shown outwards immediately in the functionality of the accumulator.

It is possible to list numerous different factors, which make the accumulator change to a non-operational state. Such factors are:

- to make a short circuit to the poles of the accumulator or to draw too much current from the accumulator (more than what the accumulator has been planned for),
- the load, which requires at least periodically so much current that the accumulator voltage falls considerably because of this,
- to keep or use the accumulator in considerably low or high temperatures,
- to use a non-compatible charger to charge the accumulator,
- too high charging voltage or too long charging time,
- to let the accumulator to discharge completely empty,
- to let the electrolyte concentration to fall below the recommended minimum value in liquid accumulators,
- to use a liquid containing some other unsuitable electrolyte instead of adding distilled water in liquid accumulators,
- to apply strong vibration or impact to the accumulator.

In the invention accelerated life testing is conducted to the accumulator. All variables affecting the service life are taken into account in the testing, or the most essential variables of these are selected. As a result there is the theoretically estimated service life of the accumulator. It can be said that in this case it concerns a long-term principle for the prediction of service life.

In addition, the accumulator's actual situation i.e. its use parameters and environmental conditions are measured, and this way information is obtained on the behaviour of the accumulator as the function of change in different parameters. For example, if it is known that the accumulator has been in use for 2 years at the moment of examination, and its temperature has been monitored all this time (continuously or periodically), a considerable amount of information has been obtained on the extreme temperatures experienced by the accumulator in the period of two winters and summers and their times of influence. In the same connection the extent of accumulator voltage and capacity as function of passed time is obtained as measurement data. In the present invention results of the theoretical service life examination are combined with the actual parameters of the accumulator measured at appropriate moments of time and, if needed, also within a longer period of time, repeating the measurements and/or calculation. This way it is possible to predict an estimate of the termination of the accumulator's service life better than before. The measurement and calculation data in question are recorded and transferred over a telecommunications network to an appropriate server or cloud service, and the data can be marked with accumulator-specific ID codes (i.e. identifier data) so that the data is easily accessible also at a later date.

In the present invention, the data on the remaining service life of the accumulator is reported to the user or owner of the vehicle or other desired party by transmitting it from the cloud service or the above-mentioned server over a telecommunications network to the holder's or user's mobile phone or e-mail on the specific request by the user or service provider.

The present invention also makes possible the more short-term measuring of operational state, prediction of the near future and relating communications to a party interested in this data. An example of short-term prediction can be, for example, a situation in which the accumulator has been in cold conditions for a long time so that the rest voltage has dropped from the rest voltage of the normal operating temperature of +25°C. In cold conditions, the accumulator is not able to receive a sufficient amount of power. When the measured rest voltage falls below a pre-determined critical threshold value, the system activates alarm data, which can be reported to the user. The data can be formulated sensibly from the point of view of practical life of the vehicle; for example, to the form: "There is not enough power in the accumulator for the next start, if the temperature conditions do not significantly change" or "The accumulator shall be made warm and then charged full".

In the present invention the measurement of just a few parameters is enough for the prediction of the said near future: these are the rest voltage of the accumulator, the temperature of the accumulator, and time. In an embodiment the location information of the accumulator can be connected to the above-mentioned parameters, through which the temperature forecast of the near future on a short or long period of time can be linked to the data. The temperature prediction is obtained from servers providing weather services, and for this there are plenty of options. Naturally, it has to be taken into account that the accuracy of the temperature prediction grows considerably weaker as function of time, and a prediction extending even to a week includes big factors of uncertainty. Averaged temperature data relating to seasons is of course known with a better accuracy, and this data can also be used in the above-mentioned embodiment.

In an embodiment of the invention it is sufficient for the observation of the present state of the accumulator and for the near-future prediction that the rest voltage of the accumulator is measured and the location data of the accumulator is found out. On the basis of the location data, temperature data at the location of the accumulator can be obtained from external servers, such as providers of weather services. At the same time also the temperature predictions of the near future can be taken for processing. In this case it is possible to manage without separately measuring the temperature directly from the accumulator. Information on the present state of the accumulator can be found out on the basis of this data, and the information can be recorded to a cloud service. Depending on whether the data gives grounds to user information, the data or alarm is reported to the user of the vehicle or other party interested in the data, if needed.

When intelligence is added to the data to be reported to the user of the vehicle so that the user is not only told that the accumulator is non-operational and has to be replaced, but instructions are given for restoring the performance of the accumulator, for example, by simply bringing the accumulator to a warm state and by charging the thus heated accumulator, unnecessary replacements of accumulators can be eliminated to a considerable degree. The estimate of the service life of the accumulator or the operational state information of the accumulator to be reported to the user can also be provided with free-form instructions for bringing the accumulator back to operation.

In an embodiment of the invention only the voltage of the poles of the accumulator are measured from it. When the accumulator voltage falls below the set threshold value, and the voltage stays below the threshold value for a sufficiently long time, it is concluded that the vehicle with its accumulator is no longer in active use. As an example it can be mentioned that as the accumulator voltage falls below, let's say, 10V, and for example 6 months has lapsed, the radio transmitter of the apparatus starts to transmit a positioning signal. The said positioning signal can be located with an appropriate receiver; this has been described in more detail above.

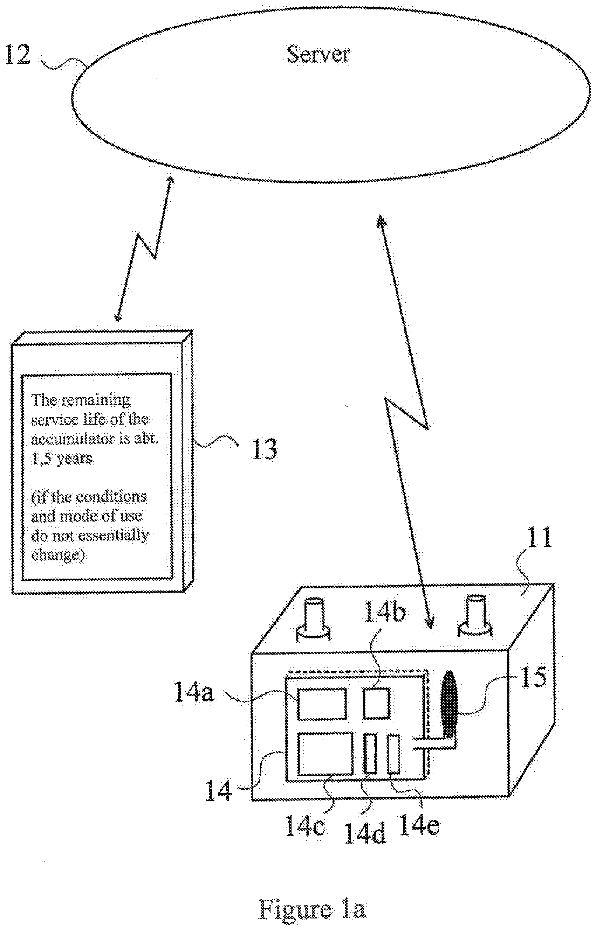

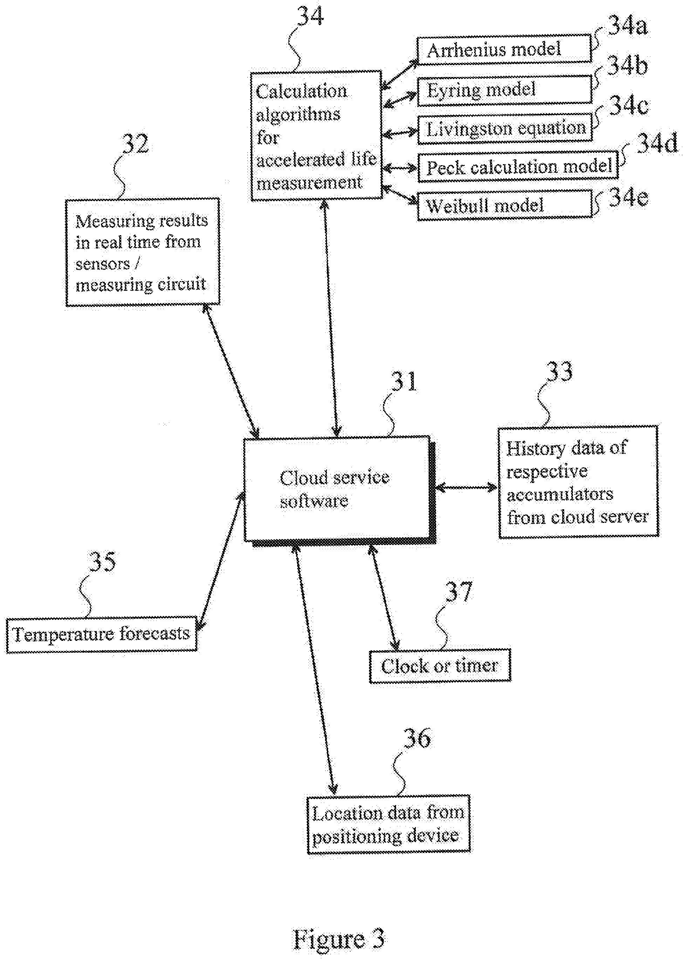

Figure 1a illustrates a monitoring arrangement for an accumulator as a simplified example, i.e. a measuring circuit and antenna connected to the arrangement, and principles for recording the data and providing the user information. The core of the equipment is the accumulator 11, which is depicted as a simplified box with accumulator poles shown on its upper surface. The circuit board 14 functions as the measuring unit for the monitoring, the circuit board in this example being integrated with measuring sensors and necessary data processing circuits 14b-d and also the positioning module 14a. The possible sensor types have been described above. The number of sensors in the Figure is only exemplary, and in reality it can vary from one to a bigger number of different types of sensors. The controller 14e locally controlling the operation of the measuring unit is also located on the circuit board 14. When needed, a local memory module can be coupled to the circuit board. The antenna 15 works as the transmitter-receiver of the measuring unit, the main beam of which is directed outwards from the outer surface of the accumulator for maximizing the radiation power. The transmitter-receiver communicates over a network, and at the other end there is provided the server 12 with necessary software for the actual long-term recording of data and management of calculation logic. The programmable parts used by the server 12 and different possible input data for the prediction algorithm of service life are described in more detail in Figure 3. The user and flow of information expressly to the direction of the vehicle's owner or user is illustrated by the mobile phone 13, to which the server can send notices, alarms, information on the remaining service life of the accumulator, and other desired information relating to the accumulator and conditions relating to its operation. The data can be in the form of an SMS, e-mail or another notice conveyed by another type of application.

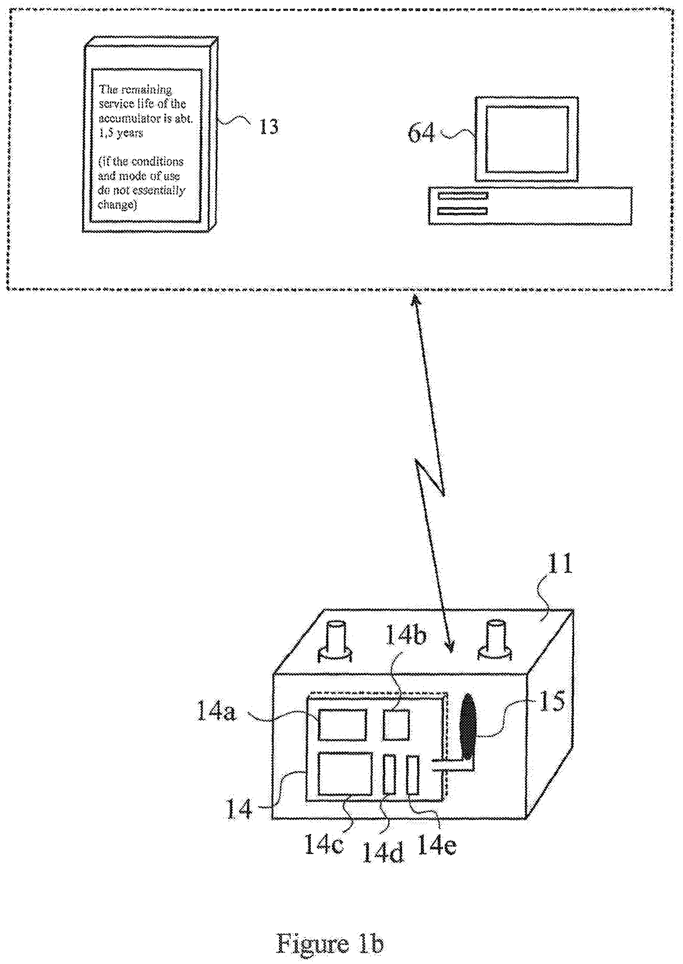

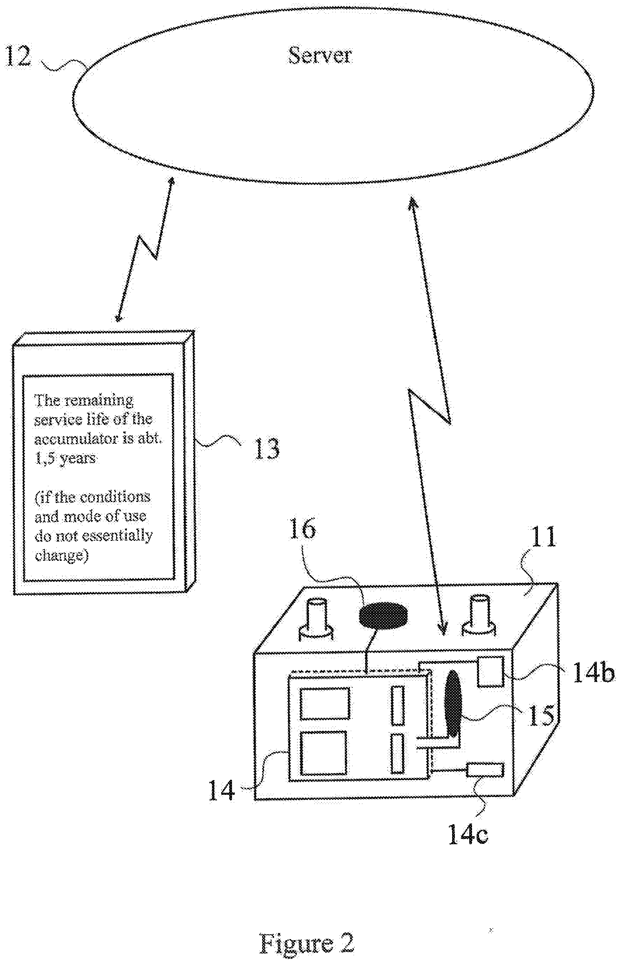

Figure 1b illustrates the situation in Figure 1a in a further simplified form of an example. The measuring unit 14 of the accumulator 11 contains the needed sensors, memory, positioning module and data transmission equipment (and receiver equipment, if needed); these are described by the components 14a-14e. The data is transmitted via the antenna 15. The receiving end is illustrated in a simplified form by the mobile terminal device 13 of the party interested in the accumulator data, i.e. the user of the accumulator, authority, company or other respective party interested in the accumulator, or by the computer 64 used by the said party. In the simplest example the data on the termination of the accumulator's service life is a simple signal (which is depicted as positioning signal in connection with Figure 2), the transmission of which starts via radio by command of the controller 14e on the basis of the measurement data. The RF signal in question is received and indicated as a message on the display of the terminal device of the receiving party. Several examples of the transmission modes of the signal and the possible processing of data and information content are provided later.

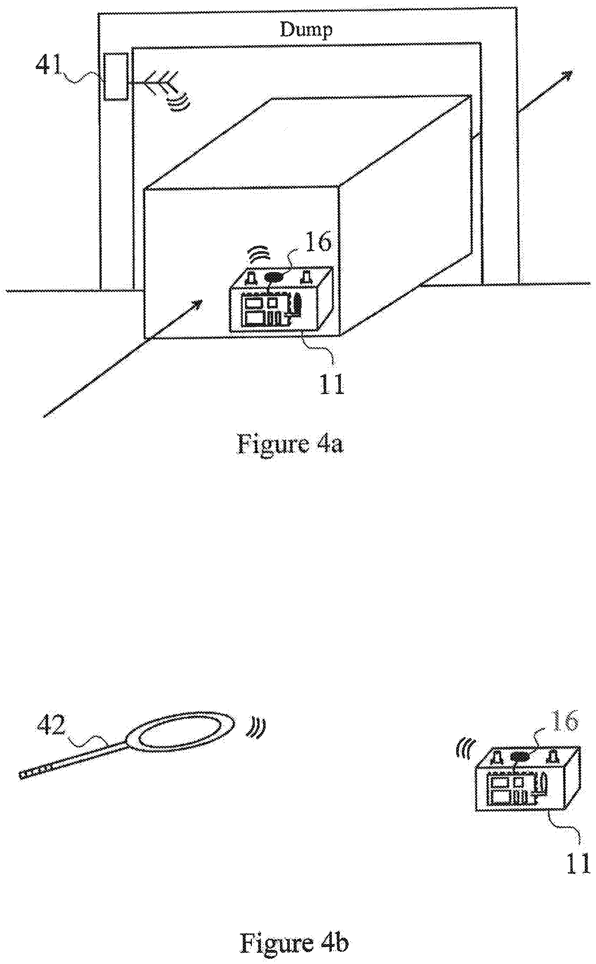

Figure 2 illustrates second exemplary equipment, the main elements of which are the same as in Figures 1a and 1b. An essential difference are the elements coupled to the accumulator 11, in which the measuring unit takes care of the assembly of measuring results, local recording and transmission via an antenna to the direction of the server. In Figure 2 the module managing the positioning is a separate unit 16, which in Figure 2 has been connected to the upper surface of the accumulator. From the positioning module 16 there is provided a coupling to the measuring unit 14. Also the sensors (such as the temperature sensor 14b and humidity sensor 14c) can be installed to a desired place in the accumulator or on its outer surface or in its proximity, in which case separate couplings are required from the sensors to the measuring unit. The apparatus in Figure 2 can be set to operate so that when the measuring unit 14 has detected for a set uniform period of time that the accumulator is no longer operational, the positioning module 16 starts to transmit a positioning signal through the antenna 15, which can be detected from outside. The positioning signal can be an RF signal without any specific information content, or the RF signal can contain specific information, such as coordinates for the location, data identifying the accumulator, or other data expressing the location. An example of the detection of the signal with reception options is found in Figure 4.

In Figure 3 there is shown a principle of the measurements and calculation and of the parameters used in the prediction of the service life of the accumulator by means of software 31 of the cloud server. The software in question is in the centre 31 of the Figure, and the algorithms used by it and input data are in the other boxes in the Figure. Measurement results 32 obtained from the sensors and the measuring unit and the monitored accumulators themselves are an essential part of data needed in the calculation logic. Previous measuring results are obtainable from history data 33 recorded to the server, which comprise the previous measuring results for all accumulators monitored by the system. The system includes an option to other input data, which can be manual or automatic. An example of the latter situation is the use of locality-specific temperature predictions obtained from Internet servers for the more exact anticipation of the future conditions of the monitored accumulator, and for the use in the prediction of service life. Also the positioning data 36 of the accumulator is an essential input data for the server, and clock data is essentially linked with the measurements. The clock or timer 37 can be placed to the server, and the clock data or time stamp can be transmitted from there to the measuring unit of the accumulator in connection with the measurement command. Thus the server 31 can actively initiate the start of the desired measurement at a desired point of time.

In addition Figure 3 shows examples of algorithms 34a-e used in the prediction of the life cycle, which have been described especially in the specification section above. The calculation algorithm is based on accelerated life testing 34. Depending on the input parameters and their number, the appropriate model is selected. Examples of the models are listed in the figure: the Arrhenius model 34a, Eyring model 34b, Livingston equation 34c, Peck calculation model 34d and Weibull model 34e. A more detailed description of these calculation model and their use and input parameters is found above. If needed, some other model can also be used in the system or the examination can be simplified as a situation, in which the predicted service life is concluded directly on the basis of, for example, the alarmingly low accumulator voltage or the alarmingly low specific weight of the accumulator acid. In this case it can be concluded even without a specific calculation that the predicted service life is 0 i.e. the accumulator is in a dead state.

In an embodiment of the invention a combination of two or several calculation models mentioned above (or equation instead of a model) can be used in the prediction, when needed.

The measurement results functioning as input values for the algorithm in Figure 3, previously recorded data on the server, or service life predictions or alarm-type information obtained as final result can be disclosed for the use of the accumulator's user, owner, authority, party interested in the environment, party interested in accumulator data, service provider (company interested in the matter), or party, authority or company interested in positioning data. The data can be provided with authorization so that each data type has been given desired rights user or user group specifically.

In an embodiment of the invention the positioning function with signal transmitter and antenna and the necessary sensors have been placed to the accumulator itself or to the immediate proximity of the accumulator, such as onto its outer surface so that all other logic and control needed in measurements and, when necessary, in prediction, have been placed outside the accumulator. The said place outside the accumulator can be an external server, cloud service or user's terminal device with necessary applications.

In an example the measuring unit transmits data relating to the accumulator directly to the user's terminal device. In another example the user can establish a connection from their own terminal device directly to the measuring unit and thus have access to the measurement data. Especially the positioning signal information on a dead accumulator can well travel directly through the mobile phone network or Bluetooth (BT), or by means of a necessary application directly between the accumulator and user. One example option is to use wireless local area network i.e. WLAN to transmit data between the measuring unit and the server of the monitoring party. In one example the mobile phone functions as WLAN base station, which is in local area network connection with the measuring unit.

In an embodiment of the invention the user's own mobile phone or other terminal device, which is connected to the accumulator's measuring unit via Bluetooth or WLAN functions as the transmitter-receiver for the measuring unit. In this case the respective Bluetooth or WLAN functionality is also required at the measuring unit. When the connection is established, for example, as the user (and at the same time the user's mobile phone) gets sufficiently close to the vehicle (and thus also the accumulator), the measuring unit transmits the data recorded to the memory unit over the Bluetooth or WLAN connection. The measurement data can thus be obtained directly to the user's mobile phone without a separate external server. If it is desired to include also analysis functions, the mobile phone transmits the data further over the network to the server. In this case information on the accumulator's operational state and/or, if needed, on the service life prediction and/or instructions is also obtained on the display of the mobile phone in addition to pure measurement data.

In principle any other BT-compatible transmitter-receiver physically located in the near proximity of the accumulator can be in place of the user's mobile phone. Figure 4a illustrates the positioning and finding of an accumulator fallen out of use as a practical example. The place in the example is the gate of a dump, to which the transmitter-receiver 41 has been installed. The receiver is able to actively measure positioning signals transmitted by the accumulator's monitoring equipment either continuously or only during the opening hours of the dump. In a situation, in which the accumulator 11 is at the end of its service life, the positioning signal has been activated after a desired time (the process for this has been described more closely above). This is depicted by the positioning module 16, which transmits the positioning signal around wirelessly as an RF signal. For example, when a load of waste or a vehicle removed out of use arrives in through the gate of the dump, the transmitter-receiver of the gate detects the positioning signal level to rise at the time the load of waste passes, and the transmitter of the gate transmits information on this to the supervisor of the dump or a respective party. The information may also be in the form of an alarm at the gate, in which case the specific nature of the load is revealed in the form of a voice or light signal directly at the gate or, for example, on the computer display in the monitoring room. This way it can be prevented that an accumulator at the end of its life cycle, considered as hazardous waste, would have time to get mixed and lost among the dump waste. The system makes possible that the accumulators can be efficiently brought to recycling, and through reuse away from spoiling the nature.

The above-mentioned example can also be executed by means of a wireless local area network (WLAN) in a respective manner as with Bluetooth.

Instead of a fixed gate receiver it is possible to use a manual movable receiver, which can detect positioning signals of accumulators. When the received level of an RF positioning signal exceeds a set detection threshold, it can be concluded that the accumulator is located within a certain radius of this movable "positioning rake". An apparatus of this type can be used manually for a closer positioning and finding of an accumulator, for example, among dump waste, if the gate receiver has not been in use.

Receivers of the above-mentioned type can in one example option be placed to garbage trucks or other moving vehicles. This makes possible that accumulators can be effectively collected and brought for recycling already before the load of the garbage truck is emptied on the dump. A movable receiver makes possible even the scanning of a whole built-up area from dead accumulators and in the places, in which the receiver gives a signal a closer search can be made with a hand-held receiver. Such a search mode can be applied more widely to any nature, city or water area under examination, which in this sense is desired to scour of dead accumulators.

The above-mentioned manual search device is described in Figure 4b. The manual receiver i.e. positioning rake 42 is a hand-held mobile device equipped with a receiver for expressing the positioning signals. The positioning rake supplies a signal to the user, if the signal transmitted by the positioning module 16 of the accumulator 11 is visible for the receiver 42. The threshold distance is naturally strongly dependent on the strength of the positioning signal in the transmission end. This shall be set to suit the practice.

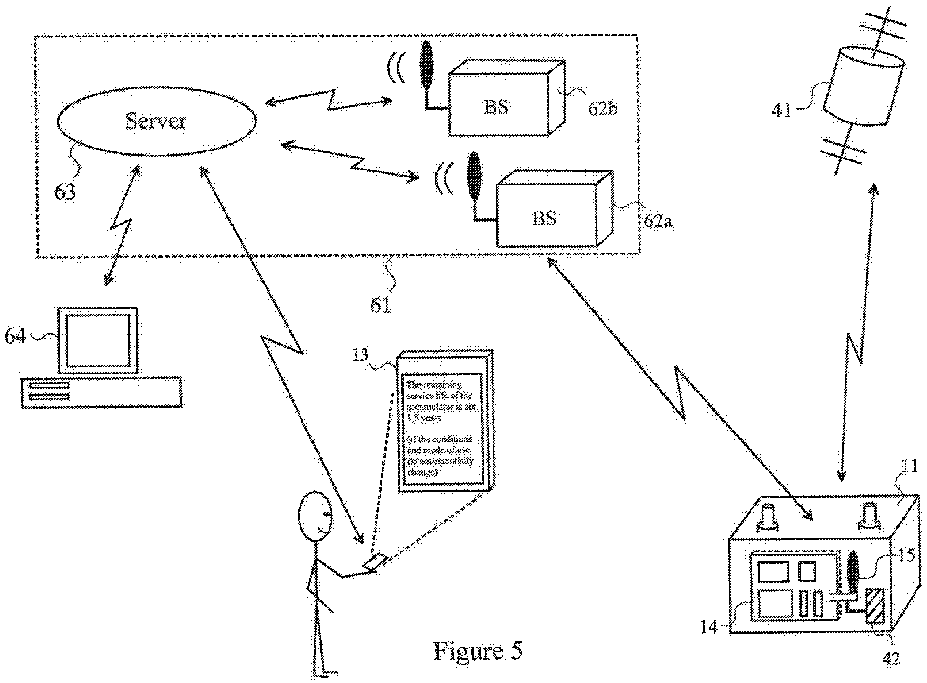

Figure 5 presents an example, in which the GPS satellite 41 functions as the source for positioning data and in addition to this, the data of the measuring unit is transmitted to be stored to the server 63 via telecommunications network, such as mobile phone network 61. In the apparatus example the measuring unit 14 of the accumulator is attached to the vertical side surface of the accumulator 11. From the measuring unit 14 there are provided the necessary couplings for measuring the accumulator voltage, electrolyte, accumulator capacity etc., as has been described more extensively above. The antenna 15 used by the measuring unit and positioning is connected to the measuring unit its transmission beam directed to an advantageous direction (for example up, diagonally upwards or to the side), considering the travel of data; naturally assuming that in a typical situation of use the accumulator is located "right side up" and in horizontal plane. The receiver 42 for the GPS signal is placed to the flank of the accumulator, and from it there is provided a coupling to the measuring unit 14 and antenna 15. The GPS receiver 42 receives GPS signals transmitted by satellites 41 (only one of which is depicted in the figure), and calculates its location information from these signals in a manner familiar to the known technology. This way the location information of the accumulator or battery in question can be recorded directly to the memory of the measuring unit 14 in data format. Thus it can be avoided that the transmitter of the measuring unit would have to transmit, for example, an especially strong signal so that the possible receiver could identify the dispatch from a sufficiently long distance away on the basis of the mere amplitude. When in the example the location information is included in the other measurement data, the desired combination of measurement and location information can be transmitted via the mobile phone network 61 in the same way as if the measuring unit were a separate mobile phone. The mobile phone network 61 is described in a simplified manner with the base stations 62a, 62b (BS) and the server 63 is included in it, to which the data is recorded after having travelled over the telecommunications network. The server 63 can be a cloud server, a server part of the mobile phone network, a server of an authority or a party interested in the matter, to mention just a few examples. From the server the measurement data with the location information can again be directed for the use of a desired party, which in Figure 5 is represented by the computer 64. If 63 represents the server of cloud service, the terminal device 64 could be, for example, a computer of an environmental authority or that of the representative of a dump company. In this kind of an example the location information could be, for example, in the form of a map, which would show all monitored accumulators at the end of their life cycle on a desired area. One option for reporting the data and algorithmic results is to report the accumulator data (comprising for example information on the remaining service life or on the accumulator being dead) directly to the holder or user 65 of the accumulator to their mobile phone or other terminal device 66 via the mobile phone network 61 for example when this concerns a vehicle or personal device. If the monitored accumulator or accumulator system is for example the main or reserve power source of a factory, reports of the accumulator's state and/or service life with identification data can be directed to the employee in charge of the apparatus, their superior or director 65 in charge of the equipment, for example, to their personal mobile station 66.

Also other data besides location information can be transmitted via satellite. This information can be control data meant for the controller of the measuring unit of the accumulator. A time message can be linked with the information, i.e. it is possible to give the time when the measurement data is to be transmitted from the measuring unit outwards via RF.

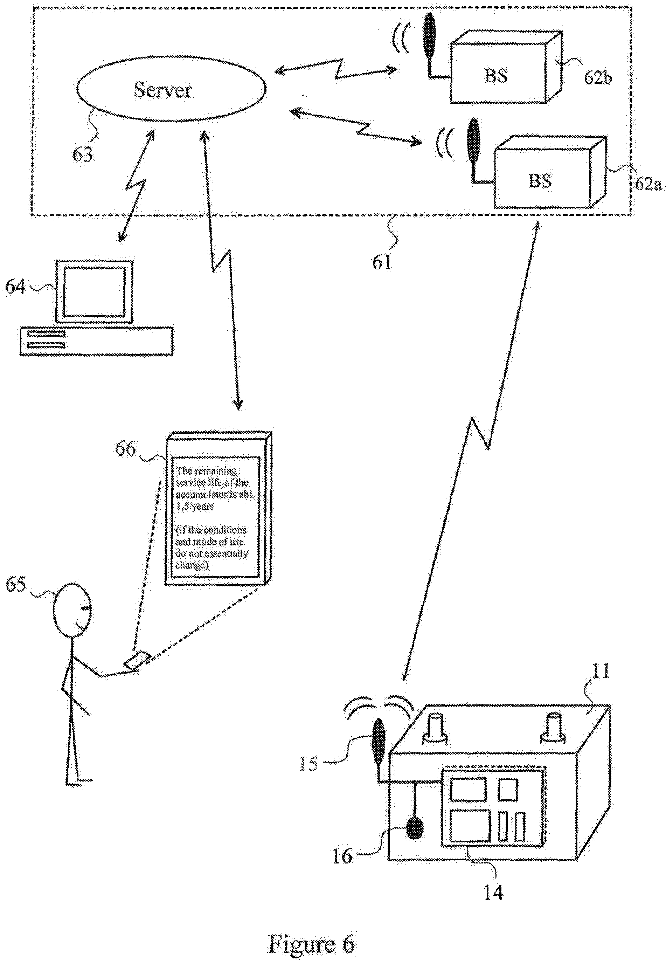

Figure 6 illustrates a slightly similar example as Figure 5, but GPS positioning has been replaced by the transmission of the positioning signal via the positioning module 16 and the antenna 15 of the measuring unit 14. The telecommunications network can be a mobile phone network or some other network, as in Figure 5. The measuring unit 14 is attached, for example, to one side or on top of the accumulator 11. The functionalities of the measuring unit 14 are the same as what has been described above, with necessary sensors and couplings. The measuring unit 14 contains a local recording module (i.e. memory), which can be deleted at a desired moment, for example immediately after having received an acknowledgement of the transmission of previously recorded data and recording to the server. The positioning module 16 generates an activation of the positioning signal, when it is desired to transmit data. A typical example for triggering the transmission moment of the positioning signal is the accumulator having been non-operational for a sufficiently long time. The equipment also contains a reserve power source for the measuring unit (not in Figure), which is activated when the accumulator itself is no longer able to give out power. The positioning signal is received in the mobile phone network 61, which is illustrated by base stations 62a, 62b, the equipment for recording the data to the network being illustrated by the server 63, to which the transmitted positioning data and desired measurement data is finally recorded. The analysis of the data with the prediction of service life can be made on the server 63, but it is also possible to direct this phase to be executed, for example, programmatically on the server of the service provider or terminal device 64. The transmission of the measuring data (and prediction data, if needed) and the informing to desired parties can be performed to the terminal device 64 of the service provider (or authority or similar), or to a manually operated device, for example a tablet or mobile phone of the end user 65, such as the owner of the accumulator. The same options apply here as what has been described in connection with the examples above.

In an example the transmitted positioning signal also contains data relating to the identification of the accumulator. Such data is, for example, the name of the accumulator's owner or the serial number and type of the accumulator. When data concerning dead accumulators arrive at the server, or when the locations of dead accumulators are shown as dots in the map application, the owners of these accumulators can be found out this way from the server or possibly by combining data from several registers.

In an example the positioning data transmitted by the measuring unit can also be used for other service applications, such as locating a stolen vehicle. This application offers to authorities a new type of tool for locating stolen vehicles and for solving crimes relating to this.

The service application concept mentioned above can be extended so that the data bus offered between the measuring unit in connection with the vehicle's accumulator and an external party is also used for other types of intelligent communication applications, which are offered for newer vehicles and car models. In this case the data is pulled from the vehicle's own data bus and directed to the data bus described above between the measuring unit and the recipient of the data. Possible services are the transmission and reception of information between the system and driver relating to the vehicle's drive parameters, manner of driving, reporting the remaining amount of fuel, alarm application (notice to the emergency centre in case of an accident), and various reminders. Further possible options are the transmission of different defect codes and response to a fault report from the service centre, reading and transmission of different function parameters of the motor, positioning of the vehicle for navigation applications and theft and emergency situations, and also for finding a parked car. The services can be called remote diagnostics, in which case the state of the accumulator and control devices can be monitored constantly. Intelligent applications comprise a wide range of services, which the users of vehicles may need, or which could be beneficial when informing of or acquiring the manner of driving, routes, external services or emergency centre services. Services may also comprise, for example, possibilities of towing and road service on the basis of the vehicle's location data, reporting the weather information to the driver, suggestions of route options for example due to changes in weather conditions, transmission of driving manner instructions, recording and maintaining of logbook and driven routes in the database (for example easy distinction between work and leisure drives for making a specification of travelling expenses to the employer), real-time reporting of fuel consumption and transmission of reminders relating to regular maintenance and motor vehicle inspection as well as notifications relating to the service status of the car (for example: when the car can be fetched from the service) to the holder of the vehicle or some other party in charge of the vehicle. The services can be executed as a smart phone application so that the user always has easy access to the data relating to the vehicle, whether the user is in the car, in its vicinity ready to take off or, for example, at home or at work. The data can be sent either in individual or serial mode in addition to the data relating to the accumulator.

The above-mentioned data bus for the transmission of data, for example, provides an opportunity to record the driving data to the memory for a desired period of time, and the controller can transmit the recorded data to the server in cycles. The recorded driving data and accumulator data can contain small values deviating from the usual, which are not directly shown in everyday driving, but which may cause a fault later. When an actual fault affecting the driving finally appears, an analysis can be made of the old recorded driving and accumulator data and for example examine deviations from typical parameter values with the vehicle in question in the driving conditions under examination. The analysis gives an opportunity to analyse and solve more uncommon faults and tackle their reasons, which could otherwise be very difficult to unravel.

In the figures presented above the user's terminal device or computer can still be the smart phone of the holder of the vehicle, but it may also be a terminal device used by an employee of the service shop or customer service personnel of the service centre, or a data connection directly reaching the emergency centre or authority.

Returning to different example options and possibilities to place the equipment, in one example receivers 41 can be installed to vehicles, which already have a ready installed Internet connection, such as vehicles used by the Post and messenger and courier service companies. When the receiver 41 detects the signal of the transmitter 15, the receiver 41 can send it to the cloud server 12, 63 via Internet and at the same time give the vehicle's ID data and location data. A party collecting accumulators (for example a person, company or authority) can later fetch the accumulator 11 in question by locating it with the hand scanner 42. For example, the vehicle network of the Post is very wide, and this way it would be easily possible to scan wide areas, even the entire Finland, during one day. Transmitters, i.e. dead accumulators could be easily located in this way. The price of the system may only rise to be quite expensive.

A second more inexpensive example option is to install the receiver equipment 41 to only a few vehicles, such as taxis, which move in central economic areas, or to other kinds of vehicles, which drive along certain routes.

An even more exact and inexpensive way to locate the signals of the transmitter 15 are so-called unmanned aerial vehicles (UAV), which have an autopilot system. The mass of the receiver equipment is approximately 100 grams, and it is further relatively small and easy to install in aerial vehicles. Such receiver equipment is also easy to commercialize. The aerial vehicle can, for example, scan a certain section of a city in a few hours by flying back and forth between certain preselected route points.

Advantages of the invention are that by means of the prediction of accumulators' service life of the invention it is possible to avoid unnecessary changes of accumulators. When the accumulators removed from use can be efficiently reclaimed by means of positioning, the hazardous waste remaining in the nature and dumps can be reduced. Thus the recycling of accumulator for reuse can be efficiently improved to a circulation of almost 100%. In addition, an advantage in the collection of data is that consumers obtain performance and quality information relating to accumulators of different makes and types and can this way choose the best accumulator. Likewise, the data produced for the manufacturers of accumulators gives an opportunity to develop even better accumulators.

One advantage is an application made possible by satellites i.e. GPS reception, in which all accumulators at the end of their service life can be located on a desired area and shown on an electronic map. The accumulators marked onto the map thus provide the authority or company with information on the locations of hazardous waste to be collected for recycling in a graphic form. The object of use has really extensive advantages starting from environmental protection, and the collection of accumulators already landed in the nature becomes considerably faster.

The present invention makes possible numerous commercial applications, such as a wireless accumulator tester, wireless monitoring of the accumulator state, a positioning module for an abandoned accumulator or one at the end of its service life, alert function or module notifying of the end of the accumulator's life cycle either in advance or afterwards, a collection module for accumulator data and analysis of measuring results.

In an example the positioning signal is not only transmitted as the accumulator is dead. The positioning signal can namely be used already during the normal operation of the accumulator, for example in the monitoring of the vehicle's modes of operation and driving style, the monitoring of the vehicle's storage conditions (temperature when parked and during driving), and the monitoring of the accumulator's charge and discharge. In addition more widely thought the positioning signal could be used in principle as a transmission instrument for use parameters of the vehicle and accumulators already during the normal use of the accumulator, in which case also location information of transmitting vehicles could be connected to the data. It would then be possible to collect vehicle and condition data tied in place or area, which could be collected to a separate database for further processing or presentation of data.

It is also an advantage that the measuring unit with its sensors, the acceleration sensor included, can be used for reporting an accident experienced by the vehicle without having to make a separate emergency call. The emergency authorities can thus be informed of a possible serious traffic accident faster than before, and also help can arrive at the place more rapidly than before.

The presented invention is not limited merely to the applications described above, but the embodiments of the invention can vary within the protection defined by the claims.

In an embodiment of the invention the positioning data transmitted by the measuring unit can also be used for other service applications, such as locating a stolen vehicle. This application offers to authorities a new type of tool for locating stolen vehicles and for solving crimes relating to this.

The service application concept mentioned above can be extended so that the data bus offered by the present invention between the measuring unit in connection with the vehicle's accumulator and an external party is also used for other types of intelligent communication applications, which are offered for newer vehicles and car models. In this case the data is pulled from the vehicle's own data bus and directed to the data bus described above between the measuring unit of the invention and the recipient of the data. Possible services are the transmission and reception of information between the system and driver relating to the vehicle's drive parameters, manner of driving, reporting the remaining amount of fuel, alarm application (notice to the emergency centre in case of an accident), and various reminders. Further possible options are the transmission of different defect codes and response to a fault report from the service centre, reading and transmission of different function parameters of the motor, positioning of the vehicle for navigation applications and theft and emergency situations, and also for finding a parked car. The services can be called remote diagnostics, in which case the state of the accumulator and control devices can be monitored constantly. Intelligent applications comprise a wide range of services, which the users of vehicles may need, or which could be beneficial when informing of or acquiring the manner of driving, routes, external services or emergency centre services. Services may also comprise, for example, possibilities of towing and road service on the basis of the vehicle's location data, reporting the weather information to the driver, suggestions of route options for example due to changes in weather conditions, transmission of driving manner instructions, recording and maintaining of logbook and driven routes in the database (for example easy distinction between work and leisure drives for making a specification of travelling expenses to the employer), real-time reporting of fuel consumption and transmission of reminders relating to regular maintenance and motor vehicle inspection as well as notifications relating to the service status of the car (for example: when the car can be fetched from the service) to the holder of the vehicle or some other party in charge of the vehicle. The services can be executed as a smart phone application so that the user always has easy access to the data relating to the vehicle, whether the user is in the car, in its vicinity ready to take off or, for example, at home or at work. The data can be sent either in individual or serial mode in addition to the data relating to the accumulator.

The above-mentioned data bus for the transmission of data, for example, provides an opportunity to record the driving data to the memory for a desired period of time, and the controller can transmit the recorded data to the server in cycles. The recorded driving data and accumulator data can contain small values deviating from the usual, which are not directly shown in everyday driving, but which may cause a fault later. When an actual fault affecting the driving finally appears, an analysis can be made of the old recorded driving and accumulator data and for example examine deviations from typical parameter values with the vehicle in question in the driving conditions under examination. The analysis gives an opportunity to analyse and solve more uncommon faults and tackle their reasons, which could otherwise be very difficult to unravel.

In the figures presented above the user's terminal device or computer can still be the smart phone of the holder of the vehicle, but it may also be a terminal devices used by an employee of the service shop or customer service personnel of the service centre, or a data connection directly reaching the emergency centre or authority.

Returning to different embodiment options and possibilities to place the equipment, in one embodiment of the invention receivers 41 can be installed to vehicles, which already have a ready installed Internet connection, such as vehicles used by the Post and messenger and courier service companies. When the receiver 41 detects the signal of the transmitter 15, the receiver 41 can send it to the cloud server 12, 63 via Internet and at the same time give the vehicle's ID data and location data. A party collecting accumulators (for example a person, company or authority) can later fetch the accumulator 11 in question by locating it with the hand scanner 42. For example, the vehicle network of the Post is very wide, and this way it would be easily possible to scan wide areas, even the entire Finland, during one day. Transmitters, i.e. dead accumulators could be easily located in this way. The price of the system may only rise to be quite expensive.

A second more inexpensive embodiment option of the invention is to install the receiver equipment 41 to only a few vehicles, such as taxis, which move in central economic areas, or to other kinds of vehicles, which drive along certain routes.

An even more exact and inexpensive way to locate the signals of the transmitter 15 are so-called unmanned aerial vehicles (UAV), which have an autopilot system. The mass of the receiver equipment is approximately 100 grams, and it is further relatively small and easy to install in aerial vehicles. Such receiver equipment is also easy to commercialize. The aerial vehicle can, for example, scan a certain section of a city in a few hours by flying back and forth between certain preselected route points.

Advantages of the invention are that by means of the monitoring and prediction of accumulators' service life of the invention it is possible to avoid unnecessary changes of accumulators. When the accumulators removed from use can be efficiently reclaimed by means of positioning, the hazardous waste remaining in the nature and dumps can be reduced. Thus the recycling of accumulator for reuse can be efficiently improved to a circulation of almost 100%. In addition, an advantage in the collection of data is that consumers obtain performance and quality information relating to accumulators of different makes and types and can this way choose the best accumulator. Likewise, the data produced for the manufacturers of accumulators gives an opportunity to develop even better accumulators.

One advantage is an application made possible by satellites i.e. GPS reception, in which all accumulators at the end of their service life can be located on a desired area and shown on an electronic map. The accumulators marked onto the map thus provide the authority or company with information on the locations of hazardous waste to be collected for recycling in a graphic form. The object of use has really extensive advantages starting from environmental protection, and the collection of accumulators already landed in the nature becomes considerably faster.

The present invention makes possible numerous commercial applications, such as a wireless accumulator tester, wireless monitoring of the accumulator state, a positioning module for an abandoned accumulator or one at the end of its service life, alert function or module notifying of the end of the accumulator's life cycle either in advance or afterwards, a collection module for accumulator data and analysis of measuring results.

In an embodiment of the invention the positioning signal is not only transmitted as the accumulator is dead. The positioning signal can namely be used already during the normal operation of the accumulator, for example in the monitoring of the vehicle's modes of operation and driving style, the monitoring of the vehicle's storage conditions (temperature when parked and during driving), and the monitoring of the accumulator's charge and discharge. In addition more widely thought the positioning signal could be used in principle as a transmission instrument for use parameters of the vehicle and accumulators already during the normal use of the accumulator, in which case also location information of transmitting vehicles could be connected to the data. It would then be possible to collect vehicle and condition data tied in place or area, which could be collected to a separate database for further processing or presentation of data.

It is also an advantage that the measuring unit with its sensors, the acceleration sensor included, can be used for reporting an accident experienced by the vehicle without having to make a separate emergency call. The emergency authorities can thus be informed of a possible serious traffic accident faster than before, and also help can arrive at the place more rapidly than before.

The presented invention is not limited merely to the applications described above, but the embodiments of the invention can vary within the protection defined by the patent claims.

## Claims

1. Method for predicting the remaining service life of an accumulator (11), wherein the method comprises the step of:

   - performing a theoretical accelerated life testing (34) to the accumulator (11) in a form of use level acceleration in a cloud server (12, 31, 63) wherein at least the temperature experienced by the accumulator (11) and the voltage of the accumulator (11) are used as variable parameters, thereby obtaining a theoretically estimated service life of the accumulator (11),

   **characterized in that** the method further comprises the steps of:

- taking in use history data of the accumulator (11) saved in the cloud server (12, 31, 63) which history data comprise use parameters of the accumulator (11) within currently elapsed use time comprising at least the voltage of the accumulator (11) and environmental conditions of the accumulator (11) where the environmental conditions comprise at least the temperatures experienced by the accumulator (11),
- taking in use earlier measurement results (33) and type data of other accumulators saved to the cloud server (12, 31, 63) where the other accumulators are of a similar accumulator type than the accumulator (11),
- calculating an estimate of the remaining service life of the accumulator (11) in the cloud server (12, 31, 63) by combining the theoretically estimated service life of the accumulator (11) with the history data of the accumulator (11) and with the earlier measurement results (33) and type data of the other accumulators, and
- reporting the calculated estimate of the remaining service life and/or operational state of the accumulator (11) to an owner or user of the accumulator (11), to an authority, to a supplier or supervisor of the equipment, or to other agreed party (65) over a telecommunication network to a terminal device (13, 64, 66) managed by the party in question.

2. The method according to claim 1, **characterized in that** the Arrhenius model (34a), Eyring model (34b), Livingston model (34c), Peck calculation model (34d), or Weibull model (34a), or a combination of at least two of the above-mentioned models is used as a model for the theoretical accelerated life testing (34).

3. The method according to claim 1 or 2, **characterized in that** either short-term or long-term temperature predictions (35) are used as input data in the method.

4. The method according to any of the claims 1-3, **characterized in that** free-form instructions for the user or other agreed party (65) are linked to the calculated estimate of the remaining service life or the operational state of the accumulator (11) for bringing the accumulator (11) back to operation.

**Patentansprüche**

1. Verfahren zur Vorhersage der verbleibenden Lebensdauer eines Akkumulators (11), wobei das Verfahren den folgenden Schritt umfasst:

- Durchführen eines theoretischen beschleunigten Lebensdauertests (34) mit dem Akkumulator (11) in Form einer Nutzungsgradbeschleunigung in einem Cloud-Server (12, 31, 63), wobei zumindest die Temperatur, die der Akkumulator (11) erfährt, und die Spannung des Akkumulators (11) als variable Parameter verwendet werden, wodurch eine theoretisch geschätzte Lebensdauer des Akkumulators (11) erhalten wird,

**dadurch gekennzeichnet, dass** das Verfahren außerdem die folgenden Schritte umfasst:

- Übernahme von im Cloud-Server (12, 31, 63) gespeicherten historischen Nutzungsdaten des Akkumulators (11), wobei die Nutzungsdaten Nutzungsparameter des Akkumulators (11) innerhalb der aktuell verstrichenen Nutzungszeit umfassen, die zumindest die Spannung des Akkumulators (11) und die Umgebungsbedingungen des Akkumulators (11) umfassen, wobei die Umgebungsbedingungen zumindest die vom Akkumulator (11) erfahrenen Temperaturen umfassen,
- Übernahme früherer Messergebnisse (33) und Typdaten anderer Akkumulatoren, die auf dem Cloud-Server (12, 31, 63) gespeichert sind, wobei die anderen Akkumulatoren von einem ähnlichen Akkumulatortyp sind wie der Akkumulator (11),
- Berechnen einer Schätzung der verbleibenden Lebensdauer des Akkumulators (11) in dem Cloud-Server (12, 31, 63) durch Kombinieren der theoretisch geschätzten Lebensdauer des Akkumulators (11) mit den historischen Daten des Akkumulators (11) und mit den früheren Messergebnissen (33) und Typdaten der anderen Akkumulatoren, und
- Melden der berechneten Schätzung der verbleibenden Lebensdauer und/oder des Betriebszustands des Akkumulators (11) an einen Eigentümer oder Benutzer des Akkumulators (11), an eine Behörde, an einen Lieferanten oder Überwacher der Ausrüstung oder an eine andere vereinbarte Partei (65) über ein Telekommunikationsnetz an ein Endgerät (13, 64, 66), das von der betreffenden Partei verwaltet wird.

2. Das Verfahren nach Anspruch 1, **dadurch gekennzeichnet, dass** das Arrhenius-Modell (34a), das Eyring-Modell (34b), das Livingston-Modell (34c), das Peck-Berechnungsmodell (34d) oder das Weibull-Modell (34a) oder eine Kombination von mindestens zwei der vorgenannten Modelle als Modell für die theoretische beschleunigte Lebensdauerprüfung (34) verwendet wird.

3. Das Verfahren nach Anspruch 1 oder 2, **dadurch gekennzeichnet, dass** entweder kurzfristige oder langfristige Temperaturvorhersagen (35) als Eingangsdaten in das Verfahren verwendet werden.

4. Das Verfahren nach einem der Ansprüche 1 bis 3, **dadurch gekennzeichnet, dass** mit der berechneten Schätzung der Restlebensdauer oder des Betriebszustands des Akkumulators (11) frei formulierte Anweisungen für den Benutzer oder eine andere vereinbarte Partei (65) verbunden sind, um den Akkumulator (11) wieder in Betrieb zu nehmen.

**Revendications**

1. Procédé de prédiction de la durée de vie restante d'un accumulateur (11), dans lequel le procédé comprend l'étape :

   - de réalisation d'un test de durée de vie théorique accéléré (34) sur l'accumulateur (11) sous la forme d'une accélération du niveau d'utilisation dans un serveur cloud (12, 31, 63), dans lequel au moins la température subie par l'accumulateur (11) et la tension de l'accumulateur (11) sont utilisées comme paramètres variables, obtenant ainsi une durée de vie théoriquement estimée de l'accumulateur (11),

   **caractérisé en ce que** le procédé comprend en outre les étapes :

   - de prise en compte de données historiques d'utilisation de l'accumulateur (11) enregistrées dans le serveur cloud (12, 31, 63), lesquelles données historiques comprennent des paramètres d'utilisation de l'accumulateur (11) dans le temps d'utilisation actuellement écoulé comprenant au moins la tension de l'accumulateur (11) et des conditions environnementales de l'accumulateur (11), les conditions environnementales comprenant au moins les températures subies par l'accumulateur (11),
   - de prise en compte de résultats de mesure antérieurs (33) et de données de type d'autres accumulateurs enregistrés sur le serveur cloud (12, 31, 63), les autres accumulateurs étant d'un type d'accumulateur semblable à celui de l'accumulateur (11),
   - de calcul d'une estimation de la durée de vie restante de l'accumulateur (11) dans le serveur cloud (12, 31, 63) en combinant la durée de vie théoriquement estimée de l'accumulateur (11) avec les données historiques de l'accumulateur (11) et avec les résultats de mesure antérieurs (33) et les données de type des autres accumulateurs, et
   - de communication de l'estimation calculée de la durée de vie restante et/ou de l'état de fonctionnement de l'accumulateur (11) à un propriétaire ou un utilisateur de l'accumulateur (11), à une autorité, à un fournisseur ou à un superviseur de l'équipement, ou à une autre partie convenue (65) sur un réseau de télécommunication vers un dispositif terminal (13, 64, 66) géré par la partie en question.

2. Procédé selon la revendication 1, **caractérisé en ce que** le modèle d'Arrhenius (34a), le modèle d'Eyring (34b), le modèle de Livingston (34c), le modèle de calcul de Peck (34d) ou le modèle de Weibull (34a), ou une combinaison d'au moins deux des modèles mentionnés ci-dessus est utilisé (e) comme modèle pour les tests de durée de vie théoriques accélérés (34).

3. Procédé selon la revendication 1 ou 2, **caractérisé en ce que** des prévisions de température à court terme ou à long terme (35) sont utilisées comme données d'entrée dans le procédé.

4. Procédé selon l'une quelconque des revendications 1 à 3, **caractérisé en ce que** des instructions sous forme libre pour l'utilisateur ou une autre partie convenue (65) sont liées à l'estimation calculée de la durée de vie restante ou à l'état de fonctionnement de l'accumulateur (11) pour remettre l'accumulateur (11) en service.

The remaining service life of the accumulator is abt. 1,5 years

(if the conditions and mode of use do not essentially change)

Figure 1a

The remaining service life of the accumulator is abt. 1,5 years

(if the conditions and mode of use do not essentially change)

Figure 1b

12

Server

The remaining
service life of the
accumulator is abt.
1,5 years

(if the conditions
and mode of use
do not essentially
change)

13

16

11

14b

15

14

14c

Figure 2

Figure 3

Figure 4a

Figure 4b

Figure 5

The remaining service life of the accumulator is abt. 1,5 years

(If the conditions and mode of use do not essentially change)

Server

BS 62b

BS 62a

63

61

64

13

41

11

15

14

42

EP 3 152 584 B1

23

Figure 6

**EP 3 152 584 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8198900 B

**Non-patent literature cited in the description**

- Accelerated Life Testing. Ilpo Jokela's thesis. Lahti University of Applied Sciences, 2006

- *Guidelines Using Plastic Encapsulated Microcircuits and Semiconductors in Military, Aerospace and Other Rugged Applications,* 2000